# EUROPÄISCHE PATENTSCHRIFT

(11) **EP 0 952 359 B1**
(45) Veröffentlichungstag und Bekanntmachung des Hinweises auf die Patenterteilung: **26.07.2006**
(21) Anmeldenummer: 99106283.7
(22) Anmeldetag: 16.04.1999
(51) Int. Cl.: F15B 13/08, F15B 21/08

(54) **Modulares elektrofluidisches Baukastensystem**
Modular electro-fluidic building block system
Système modulaire à blocs de construction électrofluidiques

(30) Priorität: 20.04.1998 DE 29807097 U
(43) Veröffentlichungstag der Anmeldung: 27.10.1999
(73) Patentinhaber: Bürkert Werke GmbH & Co., D-74653 Ingelfingen (DE)
(72) Erfinder: Ottliczky, Martin, 74670 Forchtenberg (DE)
(74) Vertreter: Degwert, Hartmut

(56) Entgegenhaltungen:
- EP-A- 0 621 407
- EP-A- 0 624 832
- EP-A- 0 703 391
- CH-A- 683 021

## Beschreibung

Die Erfindung betrifft ein modulares elektrofluidisches Baukastensystem.

Der elektrofluidische Teil eines solchen Baukastensystems besteht aus einem steuernden externen Bus oder Multipolanschluß und einem internen Bus, mit elektrischer Weiterschaltung durch Kabel oder Platinen.

In herkömmlicher Weise werden elektrische Ein-/Ausgabeblöcke und fluidische Blöcke von verschiedenen Herstellern auf getrennten Schienen ausgeführt und verdrahtet. Die fluidischen Anschlüsse haben keine direkte Anbindung an das Bussystem, d.h. sie werden über die elektrischen Ein-/Ausgabeblöcke des Fremdherstellers angesteuert.

Da die Schnittstellen der Module keiner Norm unterliegen, verwirklicht jeder Hersteller sein eigenes Konzept. Dies führt zu einem hohen Kosten- und Arbeitsaufwand, wenn elektrische und fluidische Komponenten unterschiedlicher Hersteller in einer Anlage verwendet werden,
wobei der hohe Verdrahtungsaufwand ebenso zu Buche schlägt wie die Tatsache, daß ein Austausch der Komponenten qualifiziertes Fachpersonal erfordert. Dadurch sind die Installations- und Wartungskosten in einer derartigen Anlage hoch.

Bei fluidischen Anlagen wird seitens der Anwender die Forderung gestellt, unterschiedliche Drücke in ein System einzuspeisen. In konventionellen Systemen kann dieses Problem nur unter hohem Kosten- und Arbeitsaufwand gelöst werden.

Aus der EP-A-0 621 407 ist eine Ventilstation bekannt, die mehrere in Reihe angeordnete fluidische Teile aufweist, die jeweils mit mindestens einem Ventil bestückbar sind. Ein Adapterteil, das in Reihe mit den fluidischen Teilen angeordnet ist, verbindet fluidische Teile unterschiedlicher Ausgestaltung miteinander. Die elektrischen Betätigungssignale für die Ventile liefert eine ebenfalls in Reihe mit den anderen Teilen angeordnete Verteilereinheit, wobei die Ventile mit der Verteilereinheit über im Innern der fluidischen Teile verlaufende elektrische Leiteranordnungen verbunden sind.

Aus der EP-A-0 624 832 ist eine elektronische Steuereinrichtung für eine modulartig aufgebaute Ventilstation bekannt, bei der eine Steuereinheit in Reihe mit mehreren Eingangs- und/oder Ausgangsmodulen und mehreren Ventilmodulen angeordnet ist. Die Ventilmodule bestehen aus einem Fluidverteiler, auf dem mehrere Ventile montiert sind. Im Inneren der Fluidverteiler ist ein Busleitungssystem vorgesehen, über das die Module mit der Steuereinheit kommunizieren.

Durch die Erfindung wird ein elektrofluidisches Baukastensystem zur Verfügung gestellt, das direkt in das elektrische System eines Fremdherstellers aus elektrischen Ein-/Ausgabemodulen integriert werden kann. Das erfindungsgemäße Baukastensystem ist im Patentanspruch 1 angegeben.

Ein in dem erfindungsgemäßen Baukastensystem verwendbares Standard-Elektrofluidmodul ist aus drei Teilen zusammengesetzt, einem fluidischen Teil, der die Sammelleitungen für die P-, R- und S-Anschlüsse enthält, einem elektrischen Teil, in dem der interne oder externe Bus verläuft und der beispielsweise mit einem Protokollchip zur Kommunikation mit der Steuerung ausgestattet ist, sowie einem Funktionsteil mit den Aktoren, z.B. Ventilen oder Stellantrieben.

Die bevorzugte Dreiteilung des Standard-Elektrofluidmoduls in elektrischen, fluidischen und Funktionsteil bietet darüber hinaus fertigungstechnisch den Vorteil einer Standardisierung der Teile, so daß mit wenigen Teilmodulen eine große Anzahl von Funktionen ermöglicht wird. Durch diese Maßnahme ist es z.B. in einfacher Weise möglich, lediglich durch den Wechsel des elektrischen Moduls das System auf unterschiedliche interne oder externe Busprotokolle einzustellen oder in elektrischen Modulen in Verbindung mit einem Sammelanschlußmodul oder Multipolmodul die Spannung zum Schalten der Aktoren bereitzustellen.

Durch Umgestaltung und Variation im Zusammenbau der Teilmodule sind erfindungsgemäß weitere Funktionen möglich. Bei den elektrischen Modulen sind dies z.B. eine elektrische Brücke, die lediglich den Bus bzw. die Betriebs- und Steuerspannung zu den benachbarten elektrischen Modulen weiterführt, oder ein Modul zur Einspeisung externer Not-Aus- Signale. Diesen können im fluidischen Teil Komponenten zugeordnet werden, die keinen elektrischen Anschluß benötigen, z.B. eine fluidische Abschottung, eine fluidische Zwischeneinspeisung oder ein Fluidmodul mit einer Blindplatte zur Überbrückung eines oder mehrerer Module ohne Funktionsmodule.

Eine bevorzugte Ausführungsform ist zur Steuerung der Aktoren direkt in ein externes Bussystem integriert, z.B. AS-I, Interbus-S usw., das die Steuer- und Datensignale von und zu der Steuerung überträgt. Zu diesem Zweck besitzt das elektrische Standardmodul des elektrofluidischen Baukastensystems einen Protokollchip, mit dem es mit der Steuerung kommuniziert. Weitere Ausführungsformen sind an Sammelanschluß- oder Multipolmodule angeschlossen und werden mit einem internen Bus, über Platinen und/oder Kabel mit Spannung versorgt und/oder können Daten übertragen. Die Modulbreite kann erfindungsgemäß in einem Raster variieren. Das Raster wird durch die Aktoren bestimmt, wobei Einfachmodule mit einem Aktor und Mehrfachmodule mit zwei, drei oder mehr Aktoren möglich sind.

In Weiterbildung der Erfindung kann jedes elektrofluidische Modul mit einem Not-Aus-Modul zusammengeschaltet werden. Zu diesem Zweck wird ein spezielles Einspeisemodul integriert, das bei Bedarf z.B. mit einem mechanischen, zwangsgekoppelten Sicherheitsrelais die Funktion einzelner bzw. beliebig vieler Aktoren ab- und zuschaltet.

Das erfindungsgemäße Baukastensystem enthält mindestens einen, in der Regel jedoch zwei spiegelbildliche Schnittstellenmodule zu den elektrischen Baugruppen des Fremdherstellers. Dieses Schnittstellenmodul enthält vorzugsweise eine Leiterplatte mit Anschlußkontakten auf beiden Seiten, abgestimmt auf die Kontakte der verschiedenen Herstel-ler. Das Schnittstellenmodul wird an dem Fremdmodul so angeschlossen, wie vom Hersteller vorgegeben, z.B. mittels Rast-, Schraub- oder Steckverbindungen. Auf der elektrofluidischen Seite kann ein beliebiges Elektrofluidmodul des Baukastensystems vorzugsweise durch Rastelemente angebracht werden.

Ferner enthält das Schnittstellenmodul in einer bevorzugten Ausführungsform die Anschlüsse und Kanäle für die fluidische Einspeisung der benachbarten Fluidmodule und ihrer Aktoren.

Als besonders günstig hat sich ferner erwiesen, die fluidische Abschottung und eine Zwischeneinspeisung zu kombinieren. Diese Kombination gestattet es, unterschiedliche Drücke in das System einzuspeisen.

In Weiterbildung der Erfindung ist ferner ein Rückmeldemodul vorgesehen, das direkt mit dem elektrofluidischen Modul gekoppelt werden kann. Dies hat den Vorteil, daß der Anwender in einfacher Weise die Rückmeldung, z.B. durch Leuchtdioden, direkt der Funktion eines Aktors zuordnen kann.

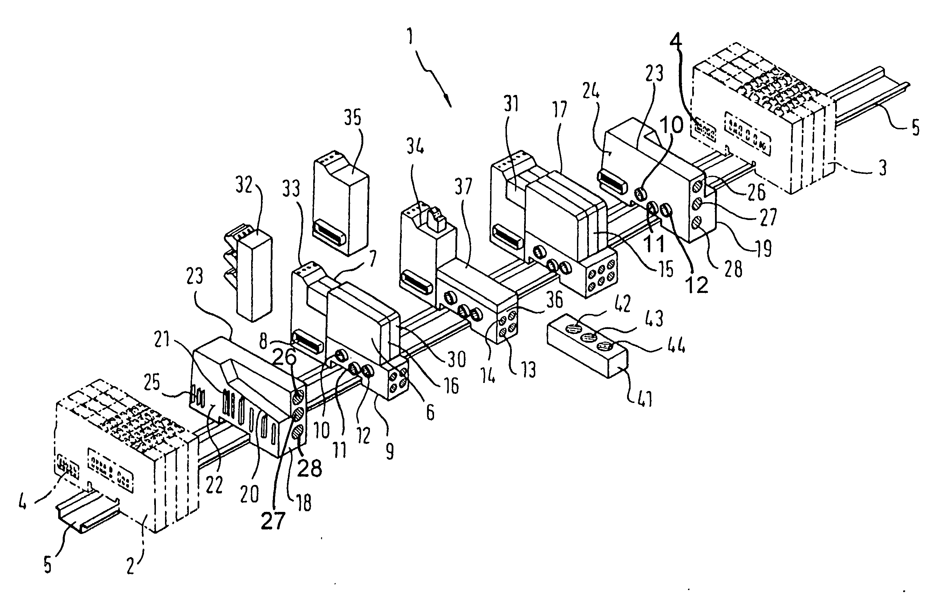

Die Erfindung ist anhand eines in der Zeichnung dargestellten Ausführungsbeispiels in der nachfolgenden Beschreibung näher erläutert.

Die einzige Figur zeigt eine schematische Explosionsdarstellung einer Ausführungsform eines elektrofluidischen Blockes zwischen zwei elektrischen Ein-/Ausgabemodulen.

In der Figur ist eine mögliche Variante des elektrofluidischen Baukastensystems 1 dargestellt, das zwischen zwei Ein-/Ausgabemodule 2, 3 eines Fremdherstellers und einen externen Bus 4 eingefügt ist. Alle Module sind auf einer Normschiene 5 befestigt und werden von einer Seite ausgehend aneinandergereiht. Elektrische Module 7 haben eine firmenspezifische Busschnittstelle 8. Fluidische Module 9 enthalten fluidische Sammelkanäle 10, 11, 12 sowie für jeden Aktor 15 zwei fluidische Ausgänge 13, 14. Die Module 6 sind als Mehrfachmodule 16, 17 mit zwei bzw. drei Aktoren 15 dargestellt.

Das Ein-/Ausgabemodul 2 des Fremdherstellers ist auf der Schiene 5 befestigt. Ein links gezeigtes Schnittstellenmodul 18 ist in seiner Kontur 20 und den elektrischen Anschlüssen 21 und der Busschnittstelle 25 auf einer Anschlußseite 22 dem Ein-/Ausgabemodul 2 des Fremdherstellers angepaßt und wird mit diesem verbunden. Die gegenüberliegende Anschlußseite 23 des Schnittstellenmoduls 18 enthält die passende Kontur 24 und Busschnittstelle 8 für das elektrofluidische Baukastensystem 1. An Anschlüssen 26, 27, 28 des Schnittstellenmoduls 18 wird die nicht dargestellte fluidische Einspeisung vorgenommen.

Ein an das Schnittestellenmodul 18 anschließendes 2fach-Modul 16 besteht aus den Teilen elektrisches 7, fluidisches 9 und Funktionsteil 30. Es hat die Breite eines zweifachen Funktionsteils 30 mit zwei angeschlossenen Aktoren 15, ihren fluidischen Ausgängen 13, 14 im Fluidmodul 9 und ihren elektrischen Schaltgeräten 31 mit Anschlüssen zum Bus 4. Der fluidische Teil 9 enthält Sammelkanäle 10, 11, 12 sowie die Aktorausgänge 13, 14 und nicht dargestellte Aktoreingänge. Dem elektrischen Modul 7 ist ein Rückmeldemodul 32 zugeordnet, das vorzugsweise auf der Rückseite 33 an das elektrische Modul 7 angerastet ist.

Anschließend ist eine elektrofluidische Einheit ohne Funktionsmodul 30 dargestellt. Ein Modul 34 mit elektrischer Not-Aus-Einspeisung ist gegen eine elektrische Brücke 35 austauschbar. Bei einem fluidischen Abschottelement 36 sind die drei Fluidkanäle 10, 11, 12 zur anschließenden 3fach-Einheit 17 abgedichtet. Eine Blindplatte 37 schließt die darunter gelegenen Fluidanschlüsse ab. Anstelle der Blindplatte 37 ist zur Druckzwischeneinspeisung das fluidische Einspeiseelement 41 mit den Anschlüssen 42, 43, 44 aufsetzbar.

Die benachbarte 3fach-Einheit 17 unterscheidet sich von der 2fach-Einheit 16 lediglich durch die Breite. Sie hat die Breite eines dreifachen Funktionsmoduls 30, d.h. mit drei angeschlossenen Aktoren 15.

Das abschließende elektrofluidische Schnittstellenmodul 19 ist spiegelbildlich zu der Schnittstelle 18, schließt das elektrofluidischen Baukastensystem 1 ab und verbindet es mit dem Ein-/Ausgabemodul des Fremdherstellers 2.

## Patentansprüche

1. Modulares elektrofluidisches Baukastensystem (1) aus auf einer Schiene (5) befestigten, anreihbaren Modulen, mit Standard-Elektrofluidmodulen, die jeweils aufgeteilt sind in einen fluidischen Teil (9), einen elektrischen Teil (7) und einen Funktionsteil (30), wobei die fluidischen Teile (9) Sammelkanäle (10, 11, 12) für Aktoranschlüsse (26, 27, 28) enthalten und die elektrischen Teile (7) Busanschlüsse (8) und elektrische Anschlüsse (44) für Aktoren (15) aufweisen, und wobei die Teile (7, 9, 30) des Standard-Elektrofluidmoduls ihrerseits modular und austauschbar sind, und mit wenigstens einem Schnittstellenmodul (18, 19), das auf einer Anschlußseite (23) eine erste Anschlußkonfiguration mit elektrischen (8) und fluidischen (10, 11, 12) Anschlüssen sowie eine Kontur aufweist, die an die Module (7, 9) des Baukastensystems angepaßt sind, und auf der gegenüberliegenden Anschlußseite (22) eine von der ersten verschiedene, zweite Anschlußkonfiguration mit elektrischen (25) Anschlüssen sowie eine Kontur (20) aufweist, die an auf derselben Schiene (5) befestigte Module (2, 3) eines fremden Modulsystems angepaßt ist.

2. Modulares elektrofluidisches Baukastensystem nach Anspruch 1, **dadurch gekennzeichnet, daß** seine Module (7, 9) zwischen zwei Schnittstellenmodulen (18, 19) mit spiegelsymmetrischen Anschlußseiten (22, 23) angeordnet sind.

3. Modulares elektrofluidisches Baukastensystem nach Anspruch 1 oder 2, **dadurch gekennzeichnet, daß** es einen internen Bus aufweist, der einen externen Bus (4) des fremden Modulsystems fortsetzt.

4. Modulares elektrofluidisches Baukastensystem nach Anspruch 3, **dadurch gekennzeichnet, daß** die Aktoren (15) des Baukastensystems (1) mit einem Sammelanschluß verbindbar sind.

5. Modulares elektrofluidisches Baukastensystem nach einem der Ansprüche 1 bis 4, **dadurch gekennzeichnet, daß** ein elektrisches Teil (7) des Baukastensystems (1) ein Not-Aus-Modul (34) ist.

6. Modulares elektrofluidisches Baukastensystem nach einem der Ansprüche 1 bis 5, **dadurch gekennzeichnet, daß** in dem Schnittstellenmodul (18, 19) die Aktoranschlüsse (26, 27, 28) und die Sammelkanäle (10, 11, 12) integriert sind.

7. Modulares elektrofluidisches Baukastensystem nach Anspruch 6, **dadurch gekennzeichnet, daß** ein fluidisches Teil (9) die Aktoranschlüsse (26, 27, 28) und die Sammelkanäle (10, 11, 12) enthält.

8. Modulares elektrofluidisches Baukastensystem nach einem der Ansprüche 1 bis 7, **dadurch gekennzeichnet, daß** in einem fluidischen Teil (9) die Sammelkanäle (10, 11, 12) auf einer Seite durch eine Blindplatte (37) verschlossen sind.

9. Modulares elektrofluidisches Baukastensystem nach einem der Ansprüche 1 bis 8, **dadurch gekennzeichnet, daß** an das elektrische Teil (7) ein den Aktoren (15) direkt zugeordnetes Rückmeldemodul (32) angeschlossen ist.

10. Modulares elektrofluidisches Baukastensystem nach einem der Ansprüche 1 bis 9, **dadurch gekennzeichnet, daß** das Schnittstellenmodul (18, 19) mit elektronischen Schaltkreisen ausgestattet ist, die ein Signalprotokoll für die erste Anschlußkonfiguration in ein Signalprotokoll für die zweite Anschlußkonfiguration umsetzen, und umgekehrt.

## Claims

1. An electrofluidic modular system (1) made up of modules which are secured to a bar (5) and may be mounted one after the other in-line, comprising standard electrofluidic modules which are each split up into a fluidic part (9), an electric part (7) and a function part (30), the fluidic parts (9) having collecting channels (10, 11, 12) for actuator ports (26, 27, 28), and the electric parts (7) including bus terminals (8) and electric terminals (44) for actuators (15), and the parts (7, 9, 30) of the standard electrofluidic module being for their part modular and interchangeable, and further comprising at least one interface module (18, 19) which has on one connecting side (23) a first connecting configuration with electric (8) and fluidic (10, 11, 12) terminals and a contour which is adapted to the modules (7, 9) of the modular system, and has on the opposite connecting side (22) a second connecting configuration which is different from the first and has electric (25) terminals and a contour (20) which is adapted to modules (2, 3) of a modular system of a different provider which are secured to the same bar (5).

2. The electrofluidic modular system as set forth in claim 1, **characterized in that** the modules (7, 9) thereof are arranged between two interface modules (18, 19) having mirror-inverted connecting sides (22, 23).

3. The electrofluidic modular system as set forth in claim 1 or 2, **characterized in that** it includes an internal bus which is an extension of an external bus (4) of the modular system of the different provider.

4. The electrofluidic modular system as set forth in claim 3, **characterized in that** the actuators (15) of the modular system (1) are connectable to a line group.

5. The electrofluidic modular system as set forth in any of claims 1 to 4, **characterized in that** an electric part (7) of the modular system (1) is an emergency OFF module (34).

6. The electrofluidic modular system as set forth in any of claims 1 to 5, **characterized in that** the actuator ports (26, 27, 28) and the collecting channels (10, 11, 12) are integrated in the interface module (18, 19).

7. The electrofluidic modular system as set forth in claim 6, **characterized in that** a fluidic part (9) includes the actuator ports (26, 27, 28) and the collecting channels (10, 11, 12).

8. The electrofluidic modular system as set forth in any of claims 1 to 7, **characterized in that** in a fluidic part (9) the collecting channels (10, 11, 12) are closed off on one side by a blind plate (37).

9. The electrofluidic modular system as set forth in any of claims 1 to 8, **characterized in that** a feedback module (32) directly assigned to the actuators (15) is connected to the electric part (7).

10. The electrofluidic modular system as set forth in any of claims 1 to 9, **characterized in that** the interface module (18, 19) is equipped with electronic circuits which convert a signal protocol for the first connecting configuration into a signal protocol for the second connecting configuration, and vice-versa.

## Revendications

1. Système modulaire électrofluidique (1) composé de modules qui sont fixés sur un rail (5) et peuvent être montés en alignement, présentant des modules électrofluidiques standards qui sont chacun divisés en une partie fluidique (9), une partie électrique (7) et une partie fonctionelle (30), les parties fluidiques (9) comportant des canaux collecteurs (10, 11, 12) pour des raccordements d'actionneurs (26, 27, 28) et les parties électriques (7) comprenant des raccordements de bus (8) et des raccordements électriques (44) pour des actionneurs (15), et les parties (7, 9, 30) du module électrofluidique standard étant pour leur part modulaires et interchangeables, et présentant en outre au moins un module d'interface (18, 19) comprenant sur un côté de raccordement (23) une première configuration de raccordement avec des raccordements électriques (8) et des raccordements fluidiques (10, 11, 12), ainsi qu'un contour adapté aux modules (7, 9) du système modulaire, et comprenant sur le côté de raccordement opposé (22) une deuxième configuration de raccordement, différente de la première, avec des raccordements électriques (25), ainsi qu'un contour (20) adapté à des modules (2, 3) d'un système de modules d'un fabricant différent qui sont fixés sur le même rail (5).

2. Système modulaire électrofluidique selon la revendication 1, **caractérisé en ce que** ses modules (7, 9) sont agencés entre deux modules d'interface (18, 19) ayant des côtés de raccordement (22, 23) à symétrie spéculaire.

3. Système modulaire électrofluidique selon la revendication 1 ou 2, **caractérisé en ce qu'**il comprend un bus interne prolongeant un bus externe (4) du système de modules du fabricant différent.

4. Système modulaire électrofluidique selon la revendication 3, **caractérisé en ce que** les actionneurs (15) du système modulaire (1) peuvent être reliés à un raccordement collectif.

5. Système modulaire électrofluidique selon l'une des revendications 1 à 4, **caractérisé en ce qu'**une partie électrique (7) du système modulaire (1) est un module d'arrêt d'urgence (34).

6. Système modulaire électrofluidique selon l'une des revendications 1 à 5, **caractérisé en ce que** les raccordements d'actionneurs (26, 27, 28) et les canaux collecteurs (10, 11, 12) sont intégrés dans le module d'interface (18, 19).

7. Système modulaire électrofluidique selon la revendication 6, **caractérisé en ce qu'**une partie fluidique (9) contient les raccordements d'actionneurs (26, 27, 28) et les canaux collecteurs (10, 11, 12).

8. Système modulaire électrofluidique selon l'une des revendications 1 à 7, **caractérisé en ce que** dans une partie fluidique (9), les canaux collecteurs (10, 11, 12) sont fermés sur un côté par une plaque aveugle (37).

9. Système modulaire électrofluidique selon l'une des revendications 1 à 8, **caractérisé en ce qu'**un module de réponse (32) directement associé aux actionneurs (15) est raccordé à la partie électrique (7).

10. Système modulaire électrofluidique selon l'une des revendications 1 à 9, **caractérisé en ce que** le module d'interface (18, 19) est équipé de circuits électroniques convertissant un protocole de signaux pour la première configuration de raccordement en un protocole de signaux pour la deuxième configuration de raccordement, et vice versa.
